Europäisches Patentamt

European Patent Office

Office européen des brevets

(11) Veröffentlichungsnummer: **0 132 006**
**A2**

(12) # EUROPÄISCHE PATENTANMELDUNG

(21) Anmeldenummer: **84201009.2**

(51) Int. Cl.⁴: **H 03 H 1/00**

(22) Anmeldetag: **11.07.84**

(30) Priorität: **14.07.83 DE 3325357**

(43) Veröffentlichungstag der Anmeldung:
**23.01.85 Patentblatt 85/4**

(84) Benannte Vertragsstaaten:
**DE FR GB IT**

(71) Anmelder: **Philips Patentverwaltung GmbH
Billstrasse 80
D-2000 Hamburg 28(DE)**

(84) Benannte Vertragsstaaten:
**DE**

(71) Anmelder: **N.V. Philips' Gloeilampenfabrieken
Groenewoudseweg 1
NL-5621 BA Eindhoven(NL)**

(84) Benannte Vertragsstaaten:
**FR GB IT**

(72) Erfinder: **Kupfer, Karl-Heinz
Krefelder Strasse 145
D-4159 Krefeld(DE)**

(74) Vertreter: **Kupfermann, Fritz-Joachim et al,
Philips Patentverwaltung GmbH Billstrasse 80 Postfach
10 51 49
D-2000 Hamburg 28(DE)**

(54) **Hochfrequenzleiterauskopplung aus einem Hochfrequenzraum mit einem Auskoppelkondensator.**

(57) Die Erfindung bezieht sich auf eine Hochfrequenzleiterauskopplung aus einem Hochfrequenzraum mit Hilfe eines Auskopplungskondensators (71). Der Auskopplungskondensator (71) ist als Chipschichtkondensator ausgebildet und an einer Schaltungsplatine (1) befestigt. Eine Kontaktfläche (73) des Chipschichtkondensators (71) ist mit der den Hochfrequenzraum abschließenden Schottwand (19) durch Anlöten elektrisch kontaktiert. An der anderen Kontaktfläche (75) des Chipschichtkondenwsators (71) wird der auszukoppelnde Leiter (77) möglichst langflächig auch wieder durch Anlöten elektrisch kontaktiert vorbeigeführt. Der auszukoppelnde Leiter (77) kann als flächenhafter Leitungszug ausgebildet sein.

FIG.7

Croydon Printing Company Ltd.

**Hochfrequenzleiterauskopplung aus einem Hochfrequenzraum mit einem Auskoppelkondensator**

Die Erfindung bezieht sich auf eine Hochfrequenzleiterauskopplung aus einem Hochfrequenzraum mit einem Auskoppelkondensator.

Zum Auskoppeln von Hochfrequenzenergie aus einem Hochfrequenzraum ist es bekannt, sogenannte Auskoppeldurchführungen einzusetzen. Bei diesen Auskoppeldurchführungen durchsetzt die Wand des Hochfrequenzraumes ein röhrenförmiger Auskopplungskondensator, durch den der auskoppelnde Leiter hindurchgezogen ist. Eine derartige Auskopplung ist zwar technisch einwandfrei, hat jedoch den Nachteil, daß sie im wesentlichen nur durch Handarbeit montierbar ist und daß sie sowohl ein Loch in der Wand des Hochfrequenzraumes benötigt als auch einen röhrenförmigen Kondensator.

Es ist Aufgabe der Erfindung, eine Hochfrequenzleiterauskopplung zu schaffen, die voll mechanisiert herstellbar ist und bei der ein Durchbruch in der Wand zum Einsetzen eines röhrenförmigen Kondensators überflüssig wird.

Die gestellte Aufgabe ist erfindungsgemäß dadurch gelöst, daß eine Kontaktfläche eines auf einer Schaltungsplatine angeordneten Chipschichtkondensators an der geerdeten Schottwand des Hochfrequenzraumes kontaktiert ist und die andere Kontaktfläche des Chipschichtkondensators dem auszukoppelnden Leiter als kontaktierende Führungsfläche dient.

Der Chipschichtkondensator kann mit der üblichen automatischen Bestückungstechnik auf der Schaltungsplatine angeordnet und mit der Schottwand verlötet werden. Wenn der auszukoppelnde Leiter an der von der Schottwand abliegenden Kontaktfläche des Chipschichtkondensators kontaktierend entlanggeführt wird, dann erfolgt die gleiche Hochfrequenztrennung entlang der kontaktierenden Führungsfläche, wie sie beim Durchführen des Leiters durch einen Röhrenauskoppelkondensator erfolgt. Aufbau und Anordnung der Auskopplung sind jedoch wesentlich einfacher.

Nach einer weiteren Augestaltung der Erfindung ist vorgesehen, daß der auszukoppelnde Leiter längs der ganzen Kontaktfläche des Chipschichtkondensators entlang verläuft. Weiterhin kann der auszukoppelnde Leiter als flächenhafter Leitungszug ausgebildet sein, der auf der Schaltungsplatine in den Hochfrequenzraum unmittelbar hinein läuft oder aber auf die Gegenseite der Schaltungsplatine durchgezogen und dann in den Hochfrequenzraum hineingeführt wird.

Die Erfindung wird anhand des in den Zeichnungen dargestellten Ausführungsbeispieles näher erläutert. Es zeigen:

Fig. 1 schaubildlich eine Explosionsansicht der Teile eines funktionsfähigen Zwischenbausteines einer Abstimmvorrichtung, wobei die Tauchseite oben dargestellt ist,

Fig. 2 schaubildlich die zusammengesetzte Abstimmvorrichtung nach Fig. 1,

Fig. 3 den aus einem Stück bestehenden Blechzuschnitt des Gehäuses,

Fig. 4 und 5 Darstellungen des Gehäuses, in das der Zwischenbaustein nach den Fig. 1 bis 3 eingelötet wird,

Fig. 6 eine als metallische Abschlußwand und als Typenschild dienende Aufklebfolie,

Fig. 7 eine Draufsicht auf den Zwischenbaustein nach Fig. 2 mit einer neuen Auskopplungsanordnung,

Fig. 8 und 9 den Aufbau einer kompakten Drei-Ebenen-Bauelementeanordnung auf einer Schaltungsplatine,

Fig. 10 eine vergrößerte Darstellung eines Schnittes X-X durch einen Rand des Zwischenbausteines vor dem Verlöten.

Im Rahmen immer kleiner werdender Peripheriegruppen an Hochfrequenzgeräten, wie beispielsweise Fernsehgeräten oder Videogeräten, ist es notwendig, die einzelnen Peripheriebaugruppen, wie auch die Abstimmvorrichtungen, in ihren Abmessungen kleiner auszulegen und dabei durch die Anwendung von automatisierbaren Arbeitsvorgängen die Herstellungskosten zu vermindern. Eine solche Abstimmvorrichtung soll beispielsweise auf die Abmessungen von etwa 51 x 34 x 12 mm begrenzt sein. In herkömmlicher Bautechnik ist bei einer derartigen Miniaturisierung Aufbau und Abgleich schwierig.

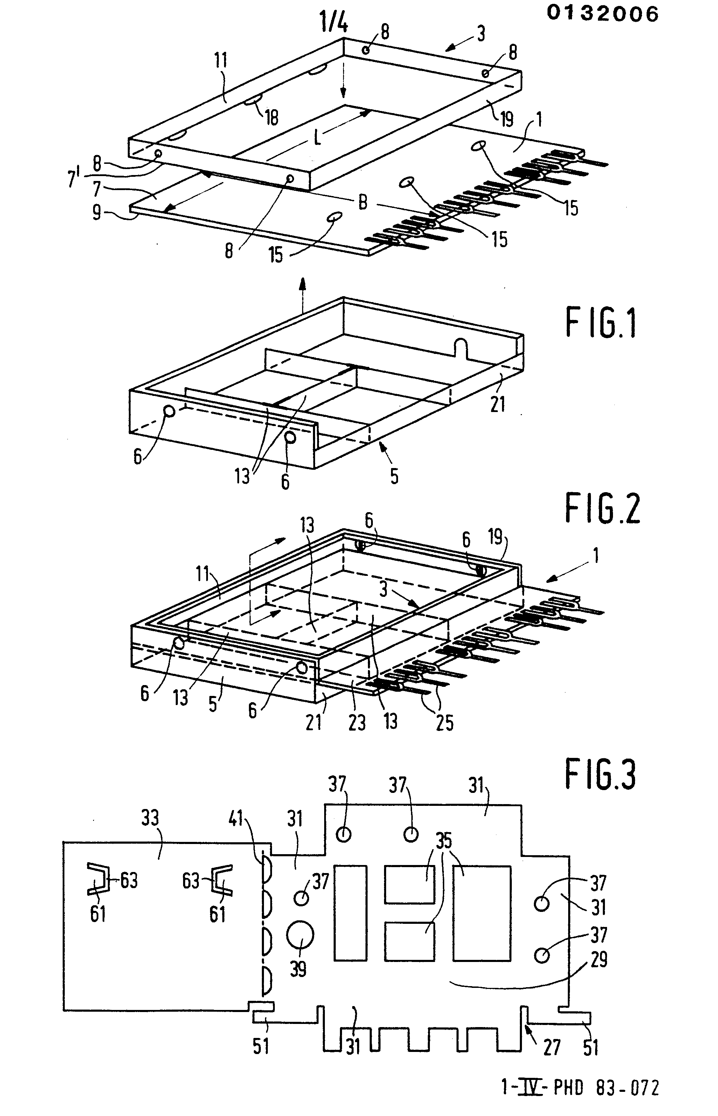

Fig. 1 zeigt in schaubildlicher Darstellung einen Zwischenbaustein, mit dem es möglich ist, schwankende Abmessungstoleranzen eines Dickschichtsubstrates 1 zuzulassen. Das Dickschichtsubstrat hat beispielsweise eine Längenabmessung L von ca. 50 mm und eine Breitenabmessung b von ca. 33 mm.

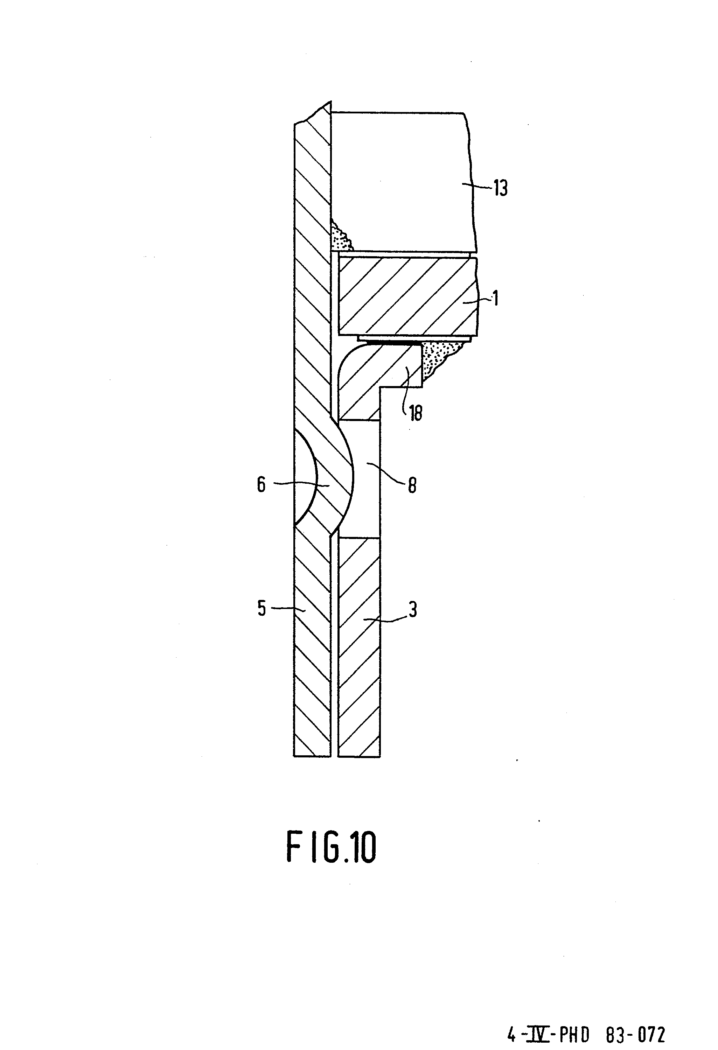

Zu dem Zwischenbaustein gehören zwei Schottrahmen 3 und 5, die flächig von der Tauchseite 7 und von der ungetauchten Seite 9 mit ebenen Kanten 8, die frei von Schwertern sind, auf das Dickschichtsubstrat auflötbar sind. Vor dem Auflöten sind Substrat 1 und Schottrahmen 3, 5 wegen der ebenen Auflage und wegen der Vermeidung der sonst üblichen Schwerter schwimmend gegeneinander verschieblich, so daß Toleranzen bequem ausgleichbar sind. Wie sich deutlich aus Fig. 2 und 10 ergibt, ist der Schottrahmen 3 ein wenig kleiner als der Schottrahmen 5. Dadurch fällt der Schottrahmen 3 beim Zusammenlegen der Teile bis auf das Substrat 1 in den Schottrahmen 5 hinein, wobei dann die äußeren Ränder in einer Ebene liegen.

Die schwimmende, Toleranzen überwindende Anbringung wird noch dadurch verbessert, daß Schottrahmen außerhalb von drei Seitenrändern der Schaltungsplatte angeordnet sind und sich vor diesen Seitenrändern überlappen und daß die Rahmen im Bereich der Überlappungen vor dem Verlöten mittels Einschnappverbindungen gegenseitig verrastet sind. Die Ränder der Schaltungsplatte liegen also immer frei, so daß die Plattenabmessungen schwanken können. Fig. 10 zeigt anhand einer vergrößerten Schnittdarstellung, wie die sich überlappenden Schottrahmen 3, 5 das Dickschichtsubstrat 1 zwischen sich schwimmend festklemmen und wie der Schottrahmen 5 mit einer Sicke 6 in ein Loch 8 des Schottrahmens 3 eingreift, wodurch die Schnappverbindung zustande kommt.

Auf dem Dickschichtsubstrat 1 befinden sich nicht dargestellte flächenhafte Leitungszüge, zu denen auch Leitungszüge zählen, die auf Null oder Erdungspotential liegen. Diese Leitungszüge sind teilweise bewußt so gelegt, daß sie Auflötflächen bilden, mit denen die Schottwände 11 des Schottrahmens 3 und die Schottwände 13 des Schottrahmens 5 verlötbar sind. Dort, wo derartige Lötflächen aufgrund der Schaltung nicht bereit stehen, sind besondere Einzellötflächen 15 vorgesehen, mit denen die Schottrahmen 3 und 5 und das Substrat 1 verlötbar sind. Am Schottrahmen 3 können abgebogene Lappen 18 vorgesehen werden, die verbreiterte Lötflächen bilden. Die außen umlaufenden Schottwände der Schottrahmen 3 und 5 erstrecken sich je nach den Toleranzen des Dickschichtsubstrates genau oder ungefähr genau längs der Ränder des Substrates 1. Zwei Schottwände 19 und 21 der Rahmen 3 und 5 machen jedoch eine Ausnahme. Diese Schottwände 19 und 21 lassen zwischen sich einen Streifen 23 des Dickschichtsubstrates 1 aus dem Hochfrequenzraum heraustreten. An diesen Streifen 23 des Substrates sind Anschlußstifte 25 angeschlagen.

Ist das Dickschichtsubstrat 1 auf später noch zu beschreibende Weise vollständig bestückt, dann werden die Schottrahmen 3 und 5 von beiden Seiten 7 und 9 auf das Substrat 1 aufgelötet, wobei dieser Lötvorgang zusammen mit dem Anlöten der übrigen Bestückungsteile erfolgt. Dabei entsteht ein voll funktionsfähiger Zwischenbautein, der auch ohne Gehäuse und ohne abschließende Deckel voll funktionsfähig ist. Dieser Zwischenbaustein läßt sich gut abgleichen, da alle seine Bauteile für Abgleiche und Fehlerkontrollen freiliegen.

Fig. 3 zeigt die Abwicklung des Gehäuses, in das der Zwischenbaustein nach den Fig. 1 und 2 einsetzbar ist. Diese Abwicklung besteht aus einem einzigen Blechzuschnitt, beispielsweise aus Weißblech. An diesem Blechzuschnitt 27 befinden sich der spätere Boden 29, die Gehäusewände 31 und der Gehäusedeckel 33. Im Boden 29 sind Fenster 35 vorgesehen. Die Seitenwände 31 weisen Lötdurchbrüche 37 auf, und eine der Seitenwände hat ein Antennenloch 39.

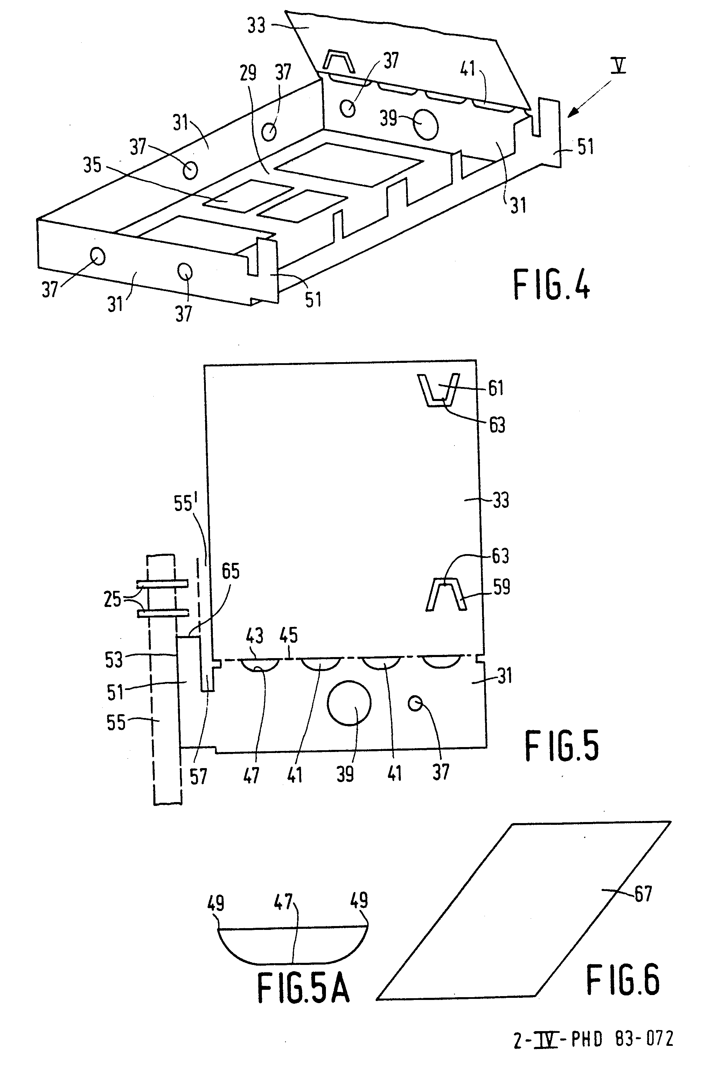

Fig. 4 zeigt nun in schaubildlicher Darstellung, wie der Blechzuschnitt 27 nach Fig. 3 durch Auffalten zu einem Gehäuse wird. Am Boden 29 erkennt man die Fenster 35. In den Seitenwänden 31 befinden sich die Lötdurchbrüche 37, und der Gehäusedeckel 33 ist über Knickdurchbrüche 41 an der Gehäusewand 31 mit dem Antennendurchbruch 39 fest, jedoch abknickbar verbunden.

In Fig. 5 ist in Richtung eines Ansichtspfeiles 5 eine Ansicht des Gehäuses dargestellt, aus der besonders deutlich zu erkennen ist, wie der Gehäusedeckel 33 mit einer der Seitenwände 31 homogen verbunden ist und bleibt. Durch die Seitenwand 31 ist der Antenneneingang hindurchgeführt. Der homogene Blechübergang von Deckel über Seitenwand 31 zum Boden sorgt für eine besonders gute Freiheit von HF-Störeffekten. Die Knickdurchbrüche 41 bestehen jeweils aus einer geradlinigen Stanzkante 43, die in die Knicklinie 45 fällt. Die andere Kante des Durchbruches 41, die Bogenkante 47, ist vornehmlich im Bereich der Enden 49 der Stanzkante 43 gebogen.

An das Gehäuse sind Fußlappen 51 angeschnitten. Diese Fußlappen 51 ermöglichen es, die Abstimmvorrichtung mit einer Vorderkante 53 vertikal auf einer gestrichelt angedeuteten Schaltungsplatte 55 hochkant aufzustellen. Die Anschlußstifte 25 können dann in diese Schaltungsplatte 55 eingelötet sein. Ebenso ist es möglich, die Abstimmvorrichtung beispielsweise in eine andere Schaltungsplatte 55' einzustecken, wobei diese Schaltungsplatte 55' in vorgesehene Nuten 57 zwischen Fußlappen und Gehäusewand 31 eindringt.

Ist der Deckel 33 auf das Gehäuse aufgeschwenkt und werden durch U-förmige Ausstanzungen 59 gebildete Stützlappen 61 ausgebogen, dann kann die Abstimmvorrichtung auf den Vorderkanten 63 der Stützlappen 61 und den Vorderflächen 65 der Fußlappen 51 im Abstand von einer Schaltungsplatte auf diese aufgelötet werden.

Ist die Abstimmvorrichtung vollständig fertig abgestimmt und betriebsbereit, dann wird auf die Fenster 35 eine Metallfolie 67 aufgeklebt, die die Fenster 35 verschließt und gleichzeitig als Typenschild ausgebildet sein kann. Das restlose Verschließen der Abtimmvorrichtung und die Aufbringung eines Typenschildes lassen sich auf diese Weise sinnvoll miteinander verbinden.

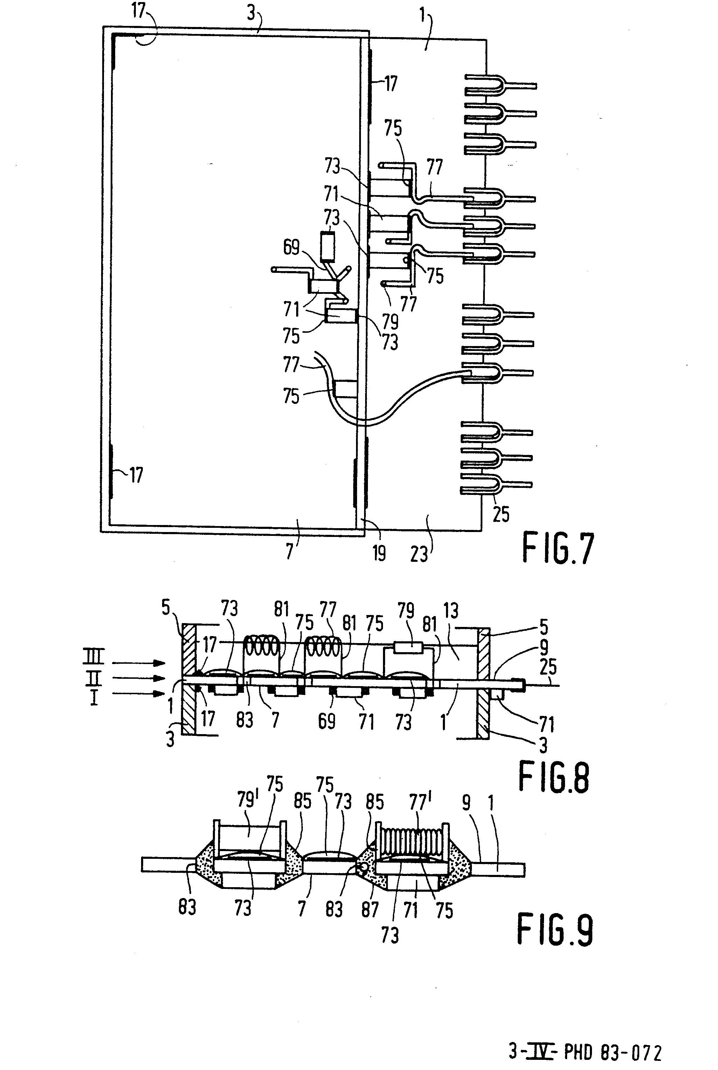

Die Fig. 7 bis 9 zeigen nun verschiedene Schaltungstechniken, mit denen es möglich ist, in möglichst gedrängter Bauweise mit einfachen Bauteilen und möglichst vollautomatisch die Schaltung des Tuners anzubringen. Das Dickschichtsubstrat 1 wird in Fig. 7 von seiner Tauchseite 7 her flächig gezeigt. Auf das Dickschichtsubstrat ist der Metallrahmen 3 aufgelötet. Lötflächen 17 sind schematish angedeutet. Auf der Tauchseite des Substrates befinden sich im Sinterverfahren aufgebrachte Leiterbahnen 69. Die Leiterbahnen verbinden einzelne Bauteile, wie auf der Tauchseite liegende Chipschichtkondensatoren 71. Das Leitungsbild ist nicht im einzelnen aufgezeichnet, weil es für die Erklärung keine Bedeutung hat.

An den über die Schottwand 19 aus dem Hochfrequenzteil herausragenden Streifen 23 des Dickschichtsubstrates sind die Anschlußstifte 25 angeschlagen. Bei vier dieser Anschlußstifte ist dargestellt, wie die Hochfrequenzenergie aus dem Hochfrequenzraum durch die Chipschichtkondensatoren im Bereich der Streifen 25 praktisch kurzgeschlossen wird, womit zu den Anschlußstiften 25 nur Nutzsignale gelangen. Zur Auskopplung dienen Chipschichtkondensatoren 71 und die Schottwand 19. Diese Chipschichtkondensatoren 71 sind zunächst auf das Substrat 1 im üblichen Bestückungsverfahren aufgeklebt. Jeder der Chipschichtkondensatoren 71 hat zwei Kontaktflächen 73, 75. Die eine Kontaktfläche 73 ist jeweils mit der geerdeten HF-abschirmenden Schottwand 19 entweder außerhalb oder innerhalb der Schottwand 19 verlötet. Längs der anderen Kontaktfläche 75 verläuft jeweils ein auszukoppelnder Leiter 77. Um eine gute hochfrequenzmäßige Trennung herbeizuführen, verlaufen die Leiter 75 möglichst über die ganze Kontaktfläche 7 der Chipschichtkondensatoren 71 hinweg und sind durch Anlöten gut kontaktiert. Auch die Leiter 77 sind als flächenhafte Leitungszüge ausgebildet. Entweder sind sie isoliert zwischen der Schottwand 19 und der Oberfläche des Dickschichtsubstrates in den Hochfrequenzraum eingeführt oder aber durch Durchkontaktierungen auf die ungetauchte Seite 9 hindurchgezogen mittels sich durch Lotbrückendurchbrüche 83 erstreckender Lotbrücken 87 und dann auf der ungetauchten Seite in den Hochfrequenzraum eingeführt. Diese Hochfrequenzleiterauskopplungen entsprechen funktionsmäßig vollständig den üblichen Rohrdurchführungen, sind aber gegenüber diesen wesentlich wirtschftlicher erstellbar.

Fig. 8 zeigt eine Drei-Ebenen-Anordnung von Bauteilen auf einem Dickschichtsubstrat 1, um so zu einer größeren Packungsdichte und einem vereinfachten Löten zu gelangen. Auf der Tauchseite 7 des Dickschichtsubstrates sind flächenhafte Leitungszüge 69 derart angeordnet, wie sie in Fig. 7 angedeutet sind. Die flächenhaften Leitungszüge erstrecken sich natürlich über die gesamte Tauchseite 7. Nach ihrem Aufkleben werden Chipschichtkondensatoren 71 mit den flächenhaften Leitungszügen 69 verlötet. Auf der Tauchseite 7 können auch integrierte Schaltungen angeordnet werden. In der Anordnungsebene, die in Fig. 8 mit I bezeichnet ist, ist es auf jeden Fall wichtig, daß nur beim Löten in das Lötbad tauchbare Bauelemente vorgesehen werden.

In einer Anordnungsebene II, die sich direkt auf der ungetauchten Seite 9 des Dickschichtsubstrates 1 befindet, sind wieder flächenhafte Leitungszüge im Sinterverfahren aufgetragen. Diese Leitungszüge verbinden teilweise Dickschichtwiderstände 73. Die Anordnungsebene II wird geschlossen mit Hilfe einer abdeckenden isolierenden Abdeckschicht 75. Nur in der dritten Anordnungsebene befinden sich konkrete, nicht tauchfähgie Bauteile, wie Spulen 77, Lackwiderstände, Dioden und weitere integrierte Schaltungen 79. Diese Bauteile haben Anschlußbeine 81, die sich durch Lotbrückendurchbrüche 83 des Dickschichtsubstrates 1 hindurch zur Tauchseite 7 erstrecken. Auf dieser Tauchseite 7 sind die Anschlußbeine 81 mit den Leitungszügen 69 auf der Tauchseite 7 verlötbar.

Das Löten der Dickschichtsubstratplatte zusammen mit den Rahmen 3 und 5 erfolgt in einem einzigen Tauchlötvorgang, ohne daß das Dickschichtsubstrat gewendet werden muß. Dies führt verfahrensmäßig zu wesentlichen Einsparungen. Das Dickschichtsubstrat wird mit seiner Tauchseite 7 in das Tauchlötbad eingetaucht. Dabei verlöten auf der Tauchseite die Kontaktflächen der Chipschichtkondensatoren 71 mit den flächenhaften Leitungszügen 69. Auch verlöten selbstverständlich eingesetzte Anschlußbeine von integrierten Schaltungen mit den flächenhaften Leitungszügen. Das Dickschichtsubstrat wird so tief getaucht, daß das Lot durch die Lotdurchbrüche 83 hindurchdringt bis auf die nicht-getauchte Oberfläche 9. Auf dieser Oberfläche können dann die von der Abdeckungsschicht 75 freien Teile der Lötflächen 17 mit den Rahmen 5 und 3 verlöten. Zum gesamten Löten ist mithin nur ein Tauchvorgang erforderlich, um alle Lötvorgänge auf beiden Seiten durchzuführen.

Fig. 9 zeigt eine Abwandlung von konkreten Bauelementen 77' und 79'. Auf der Tauchseite 7 des Dickschichtsubstrates 1 sind, wie in Fig. 8, Chipschichtkondensatoren 71 angeklebt und später angelötet. Die konkreten Bauelemente 77' und 79' haben nach Art der MELF-Technik abgewandelte Anschlüsse 85. Diese Anschlüsse 85 sind so gestaucht, daß sie nicht durch die Lotbrückendurchbrüche 83 hindurchschiebbar sind, sondern auf der nicht-getauchten Seite 9 des Dickschichtsubstrates 1 liegen bleiben. Beim Tauchen werden auch hier Lotbrücken 87 von unten nach oben durch das Dickschichtsubstrat 1 aufsteigen und auf der nicht-getauchten Seite 9 mit den gestauchten MELF-Anschlüssen verlötet. Wichtig ist dabei selbstverständlich, daß das Dickschichtsubstrat 1 so tief getaucht wird, daß genügend Lot an der nicht-getauchten Seite 9 aus den Lötdurchbrüchen 83 austreten kann, um mit den gestauchten Anschlüssen 85 zu verlöten.

Beim Tauchen des Dickschichtsubstrates 1 ergibt sich auch noch ein weiterer Vorteil bezüglich des Leitungswiderstandes der gesinterten flächenhaften Leitungszüge. Auch diese gesinterten flächenhaften Leitungszüge werden auf der Tauchseite 7 mit Lot überzogen. Dadurch wird der Leitungswiderstand dieser flächenhaften Leitzungszüge geringer.

Es muß bei dem Löten selbstverständlich dafür gesorgt werden, daß die abdeckende Lackschicht 75 auf der nicht-getauchten Seite 9 die Lötflächen 17 für die Rahmen 3 und 5 nicht abdeckt, ebenso wie die Kontaktlötflächen für die konkreten Bauteile 77' und 79' mit ihren Anschlüssen in MELF-Technik zum Verlöten freiliegen müssen.

PATENTANSPRÜCHE

1. Hochfrequenzleiterauskopplung aus einem Hochfrequenzraum mit einem Auskoppelkondensator, dadurch gekennzeichnet, daß eine Kontaktfläche (73) eines auf einer Schaltungsplatine (1) angeordneten Chipschichtkondensators (71)
an der geerdeten Schottwand (19) des Hochfrequenzraumes
kontaktiert ist und die andere Kontaktfläche (75) des
Chipschichtkondensators (71) dem auszukoppelnden Leiter
(77) als kontaktierende Führungsfläche dient.

2. Hochfrequenzleiterauskopplung nach Anspruch 1, dadurch
gekennzeichnet, daß der auszukoppelnde Leiter (77) längs
der ganzen Kontaktfläche (75) des Chipschichtkondensators
(71) entlang verläuft.

3. Hochfrequenzleiterauskopplung nach den Ansprüchen 1 und
2, dadurch gekennzeichnet, daß der auszukoppelnde Leiter
(77) als flächenhafter Leitungszug ausgebildet ist.

FIG.1

FIG.2

FIG.3

0132006

2/4

FIG.4

FIG.5

FIG.5A

FIG.6

2-IV-PHD 83-072

0132006

FIG.7

FIG.8

FIG.9

0132006

FIG.10